(19) Europäisches Patentamt
European Patent Office
Office européen des brevets

(11) Publication number: **0 426 943 B1**

(12) # EUROPEAN PATENT SPECIFICATION

(45) Date of publication of patent specification: **15.09.93 Bulletin 93/37**

(51) Int. Cl.$^5$: **C23G 5/032,** C11D 3/20, C11D 1/72

(21) Application number: **90111022.1**

(22) Date of filing: **11.06.90**

(54) **Agent and method for removing rosinbase solder flux.**

(30) Priority: **08.11.89 JP 291905/89**

(43) Date of publication of application: **15.05.91 Bulletin 91/20**

(45) Publication of the grant of the patent: **15.09.93 Bulletin 93/37**

(84) Designated Contracting States: **DE ES FR GB**

(56) References cited:
**EP-A- 0 261 718**
**EP-A- 0 275 987**
**DE-A- 2 846 088**
**DE-A- 2 847 691**
**FR-A- 2 582 546**

(73) Proprietor: **ARAKAWA CHEMICAL INDUSTRIES, LTD.**
**3-7, Hiranomachi 1-chome**
**Chuo-ku, Osaka-shi, Osaka 541 (JP)**

(72) Inventor: **Chihara, Machio**
**281-36 Ooaza-Kosaka, Tawaramoto-cho**
**Shiki-gun, Nara-ken (JP)**
Inventor: **Mizuya, Jiro**
**Seiwa-Ryo, 1-5-38 Tsurumi, Tsurumi-ku**
**Osaka-shi, Osaka-fu (JP)**
Inventor: **Okumura, Tatsuya**
**Hogyoku-Ryo, 3-1-23 Moroguchi, Tsurumi-ku**
**Osaka-shi, Osaka-fu (JP)**
Inventor: **Tanaka, Takashi**
**Hogyoku-Ryo, 3-1-23 Moroguchi, Tsurumi-ku**
**Osaka-shi, Osaka-fu (JP)**

(74) Representative: **Barz, Peter, Dr. et al**
**Patentanwälte Dipl.-Ing. G. Dannenberg Dr. P. Weinhold, Dr. D. Gudel Dipl.-Ing. S. Schubert, Dr. P. Barz Siegfriedstrasse 8**
**D-80803 München (DE)**

EP 0 426 943 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

The present invention relates to the use of a cleaning agent for removal of rosin-base solder fluxes and more particularly to the use of a specific cleaning agent for removal of rosin-base solder fluxes for assembly.

A rosin-base solder flux is used in production of modules for printed circuit boards, printed wiring boards or the like. Generally soldering is conducted to promote the union between the substrate and pins and to prevent oxidation in contact points which impairs electrical conductivity. Rosin-base fluxes are employed to accomplish the soldering as desired. After soldering, a cleaning agent is used to remove only the flux selectively and completely. When the cleaning agent fails to completely remove the flux, the remaining flux adversely affects the soldering, giving disadvantages of circuit corrosion, reduction of electrical insulating properties on board surfaces and eventual breakdown of circuits. To eliminate such potential disadvantages, the residual flux, particularly the activator present therein, is usually removed by a proper cleaning agent.

Halogenated hydrocarbon solvents such as trichloroethylene, trichlorotrifluoroethane and like flons have been heretofore used as cleaning agents for removal of rosin-base fluxes. However, stringent regulations for control of such halogenated hydrocarbon solvents have been laid down to solve or alleviate the environmental pollution problems such as the depletion of ozone layer. Currently there is an urgent demand from the electric machine industry for development of cleaning agents for fluxes as a substitute for flons.

In recent years, various halogen-free cleaning agents for fluxes have been developed, but no cleaning agent has been provided which can completely fulfil all property requirements for cleaning agents including cleaning property, characteristics meeting the environmentally acceptable standard, odor, inflammability, etc. For example, DE-A-2847691 discloses a cleaning agent for fluxes which consists of dimethyl benzene (i.e. an undesirable aromatic hydrocarbon), glycol monobutyl ether and isobutanol.

It is an object of the present invention to provide a halogen-free cleaning agent for removal of solder fluxes which is excellent in a cleaning property and substantially satisfactory in characteristics meeting the environmental quality standard, odor, inflammability, etc.

We conducted extensive research to achieve the foregoing object and found that a cleaning agent comprising as active ingredients a specific glycol ether compound and a nonionic surfactant surprisingly is free of all the above-mentioned problems. We have accomplished the present invention based on this novel finding.

According to the present invention, a cleaning agent comprising a mixture of

(A) at least one glycol ether compound represented by general formula (1);

$$R^1O-(CH_2\overset{\overset{\displaystyle R^3}{|}}{C}HO)_n-R^2 \qquad (1)$$

wherein $R^1$ is a hydrogen atom or an alkyl group having 1 to 5 carbon atoms, $R^2$ is an alkyl group having 1 to 5 carbon atoms, $R^3$ is a hydrogen atom or a methyl group and n is an integer of 2 to 4, and

(B) a nonionic surfactant; is used for removal of a rosin-base solder flux.

The present invention also provides a cleaning method for removing a rosin-base flux, the method comprising bringing the above cleaning agent into contact with the rosin-base flux on a substrate.

Examples of the glycol ether compounds of general formula (1), one of the ingredients of the cleaning agent used for the removal of rosin-base solder flux according to the invention, are diethylene glycol monomethyl ether, diethylene glycol dimethyl ether, diethylene glycol monoethyl ether, diethylene glycol diethyl ether, diethylene glycol methyl ethyl ether, diethylene glycol monopropyl ether, diethylene glycol dipropyl ether, diethylene glycol methyl propyl ether, diethylene glycol ethyl propyl ether, diethylene glycol monobutyl ether, diethylene glycol dibutyl ether, diethylene glycol methyl butyl ether, diethylene glycol ethyl butyl ether, diethylene glycol propyl butyl ether, diethylene glycol monopentyl ether, diethylene glycol dipentyl ether, diethylene glycol methyl pentyl ether, diethylene glycol ethyl pentyl ether, diethylene glycol propyl pentyl ether, diethylene glycol butyl pentyl ether; the corresponding tri- or tetraethylene glycol ethers; and the corresponding di-, tri- or tetrapropylene glycol ethers, etc. These compounds are usable singly or at least two of them can be used in a suitable combination. The glycol ether compounds of formula (1) are known or can be prepared by known methods.

The nonionic surfactant, another ingredient of the cleaning agent used for removal of rosin-base solder flux according to the invention, can be selected without particular limitation from various known surfactants in so far as it has nonionic character. Typical examples thereof are polyoxyethylene alkyl ether wherein the alkyl group has at least 6 carbon atoms, polyoxyethylene phenyl ether, polyoxyethylene alkylphenyl ether and like polyethylene glycol ether-based nonionic surfactants; polyethylene glycol monoester, polyethylene glycol diester and like polyethylene glycol ester-based nonionic surfactants; adducts of ethylene oxide and higher aliphatic amine; adducts of ethylene oxide and fatty acid amide; sorbitan fatty acid ester, sugar fatty acid ester and like polyhydric alcohol-based nonionic surfactants; fatty acid alkanol amide; the corresponding polyoxypropylene-based nonionic surfactants; and polyoxyethylene-polyoxypropylene copolymer-based nonionic surfactants. These nonionic surfactants are usable singly or at least two of them can be used in combination.

Among the above-exemplified surfactants, polyethylene glycol ether-based nonionic surfactants are desirable in view of the cleaning property and viscosity of the cleaning agent, and more preferable are known surfactants represented by general formula (2) below

$$R\text{-}O\text{-}(CH_2CH_2O)_n\text{-}H \qquad (2)$$

wherein R is a straight- or branched-chain alkyl group having 6 to 20 carbon atoms, preferably 10 to 14 carbon atoms, a phenyl group, or a phenyl group substituted with a straight- or branched-chain alkyl group having 7 to 12 carbon atoms and n is an integer of 2 to 20, preferably 5 to 20, more preferably 3 to 9.

While there is no specific restriction on the proportions of said glycol ether compound (A) and nonionic surfactant (B), they are usually used in a ratio of (A) : (B) = 95 to 10 wt.% : 5 to 90 wt.%, preferably 90 to 70 wt.% : 10 to 30 wt.%.

The cleaning agent used according to the invention, comprising the glycol ether compound (A) and the nonionic surfactant (B), is used for removing rosin-base fluxes, particularly those for assembly. Fluxes to be removed by said cleaning agent include inactive rosin fluxes consisting essentially of rosin, modified rosin or like rosin compounds, and active rosin fluxes consisting essentially of such rosin compounds and an activator such as triethanolamine hydrochloride, triethylene-tetramine hydrochloride, etc. A significant effect is produced by said cleaning agent especially when it is used for removing active fluxes for assembly.

The above cleaning agent can be brought into contact with the rosin-base flux on a substrate by the following methods. The cleaning agent consisting of the active ingredients, i.e., a mixture of the glycol ether compound (A) and the nonionic surfactant (B) is used as it is, or used in the form of an aqueous solution having a concentration of the mixture of the active ingredients in the range of more than 50% by weight but less than 100% by weight. When required, the cleaning agent may contain additives such as defoaming agent, anticorrosion agent or the like. Such additive, if used, is added in an amount of about 0.1 wt.% or less based on the weight of the cleaning agent. The substrate may be directly immersed in the thus obtained aqueous solution or in the active ingredients per se. Alternatively the aqueous solution or the mixture of the active ingredients per se may be sprayed over the substrate to flush it therewith, or the active ingredients per se or the aqueous solution may be brought into contact with the rosin-base flux on brushing by mechanical means. A suitable method is selected from these methods.

The cleaning agent used according to the invention is applied under the conditions suitably determined according to the concentration of the active ingredients in the cleaning agent to be used, the kind and amount of flux to be removed, surface area or shape of the substrate, and the like. Usually the cleaning agent of the invention is brought into contact with a flux at a temperature and for a period of time effective to remove the flux. The temperature for cleaning is usually in the range of from room temperature to about 80°C, and is preferably about room temperature. For removal of a flux on a substrate by the immersion method at, e.g.,room temperature, the substrate bearing a flux is usually immersed in the cleaning agent for about 1 to about 5 minutes, whereby the flux can be eliminated effectively. The immersion at a higher temperature not exceeding the flash point, of course, can reduce the period of time for cleaning and can improve the cleaning efficiency.

Following the cleaning operation, the substrate is then washed with water as a finishing step, whereby the cleaning agent remaining on the substrate is completely washed away. Such rinsing leads to high level of cleanness.

Such rinsing can be carried out in various ways, such as, by holding in running water, dipping in water under application of ultrasonic wave, spraying with water or the like. Rinsing is conducted at a temperature and for a period of time effective to remove the cleaning agent and to thereby achieve a high degree of cleanness. The rinsing is usually conducted at a temperature ranging from room temperature to about 70°C. When the rinsing is conducted by showering or dipping, the time required for completion of the rinsing is usually about 30 seconds to about 5 minutes. In any event, the rinsing is continued until the substrate becomes clean enough for a particular purpose.

The above cleaning agent can exhibit a flux-removing effect higher than or at least as high as conventional halogenated hydrocarbon type cleaning agents and can accomplish a high degree of flux removal.

The present invention can additionally provide the following advantages.

(a) The cleaning agent is halogen-free and does not pose the ozone depletion problem as caused by flon-type cleaning agents.

(b) The cleaning agent containing the glycol ether compound of general formula (1) is slightly inflammable. However, an explosion-proof cleaning apparatus specially designed is not required and commercially available conventional cleaning apparatus for flons is useful as it is or as slightly modified because the glycol ether compound has a flash point of above 70°C and is classified as "a petroleum of the third kind" stipulated by the Japanese Fire Services Act.

(c) The cleaning agent very low degree of odor, hence satisfactory in this regard.

According to the invention, there is used a halogen-free solder flux-cleaning agent outstanding in cleaning property and fully satisfactory in properties meeting environmental quality standard in respect of environmental disruption, inflammability, odor, etc. The present invention also provides a cleaning method using the solder flux-cleaning agent.

The present invention will be described below in more detail with reference to the following examples to which the scope of the invention is not limited.

Example 1

A cleaning agent was prepared by admixing 90 parts by weight of diethylene glycol dimethyl ether and 10 parts by weight of polyethylene glycol alkyl ether nonionic surfactant (trade name "NOIGEN® ET-135", a surfactant of formula (2) wherein R is a branched chain alkyl group having 12 to 14 carbon atoms and n is 9, product of Dai-ichi Kogyo Seiyaku Co., Ltd.).

A rosin-base flux (trade name "Resin flux #77-25", product of LONCO Co., Ltd.) was applied to the entire surface of a printed circuit board prepared from a copper-clad laminate and having thereon an exposed circuit portion and a non-circuit portion coated with a solder resist, then dried at 130°C for 2 minutes and subjected to soldering at 260°C for 5 seconds to produce a test board.

The test board was immersed for 1 minute in the foregoing cleaning agent at room temperature and the degree of removal of the flux was inspected with the unaided eye and evaluated according to the following criteria. Table 1 shows the results.

A : The flux was removed to a satisfactory extent.

B : A small quantity of the flux remained unremoved.

C : A considerable quantity of the flux remained unremoved.

Subsequently, the test board was washed with showering water and dried at room temperature for 30 seconds, and the cleanness (concentration of the residual ions) of the test board as determined according to MIL P 28809 with use of an Omega-meter 600 SE (trade name for a product of KENKO Co., Ltd.). Table 1 shows the results.

Examples 2 to 8

The degree of removal of flux and the cleanness of the best board were evaluated in the same manner as in Example 1 with the exception of changing the composition of the cleaning agent or the cleaning temperature as shown in Table 1. Table 1 shows the results.

Examples 9 and 10

The degree of removal of flux and the cleanness of the test board were evaluated in the same manner as in Example 1 with the exception of using a polyethylene glycol nonylphenyl ether nonionic surfactant (trade name "NOIGEN® EA-120", a surfactant of formula (2) wherein R is a nonylphenyl group and n is 5, product of Dai-ichi Kogyo Seiyaku Co., Lt ., Example 9), or a polyethylene glycol dodecylphenyl ether nonionic surfactant (trade name "NOIGEN®EA-143", a surfactant of formula (2) wherein R is a dodecylphenyl group and n is 10, product of Dai-ichi Kogyo Seiyaku Co., Ltd., Example 10). Table 1 shows the results.

Examples 11 to 13

The degree of removal of flux and the cleanness of the test board were evaluated in the same manner as in Example 1 with the exception of using a polyoxyethylene phenyl ether (the average number of moles of ethylene oxide added is 7, Example 11), a polyoxyethylenesorbitan monolaurate (trade name "SORGEN®TW 20", product of Dai-ichi Kogyo Seiyaku Co., Ltd., the average number of moles of ethylene oxide added is 12, Example 12) or a polyoxyethylene-polyoxypropylene block copolymer (trade name "EPAN®420", product of Dai-ichi Kogyo Seiyaku Co., Ltd. Example 13).

Table 1 shows the results.

Table 1

| | Cleaning agent composition | | | | Degree of cleaning |
|---|---|---|---|---|---|
| | Glycol ethers (parts by weight) | Surfactant (parts by weight) | Cleaning temp. | Degree of removal | Contamination of equivalent NaCl, $\mu g/cm^2$ ($\mu g/inch^2$) |
| Ex. 1 | DEGDME (9) | NOIGEN® ET-135 (1) | Room temp. | A | 0.78(5.0) |
| Ex. 2 | DEGDME (5) | NOIGEN® ET-135 (5) | Room temp. | A | 0.76(4.9) |
| Ex. 3 | DEGDME (2) | NOIGEN® ET-135 (8) | Room temp. | B | - |
| Ex. 4 | DEGDME (2) | NOIGEN® ET-135 (8) | 50°C | A | 0.79(5.1) |
| Ex. 5 | DEGDEE (9) | NOIGEN® ET-135 (1) | Room temp. | A | 0.81(5.2) |
| Ex. 6 | DEGMBE (9) | NOIGEN® ET-135 (1) | Room temp. | A | 0.74(4.8) |
| Ex. 7 | DPGMME (9) | NOIGEN® ET-135 (1) | Room temp. | A | 0.82(5.3) |
| Ex. 8 | TPGMME (9) | NOIGEN® ET-135 (1) | Room temp. | A | 0.79(5.1) |
| Ex. 9 | DEGDME (9) | NOIGEN® EA-120 (1) | Room temp. | A | 0.76(4.9) |
| Ex.10 | DEGDME (9) | NOIGEN® EA-143 (1) | Room temp. | A | 0.78(5.0) |
| Ex.11 | DEGDME (9) | PEO-ph (1) | Room temp. | A | 0.78(5.0) |
| Ex.12 | DEGDME (9) | SORGEN® TW 20 (1) | Room temp. | A | 0.81(5.2) |
| Ex.13 | DEGDME (9) | EPAN® 420 (1) | Room temp. | A | 0.81(5.2) |

(Note)

DEGDME: Diethylene glycol dimethyl ether

DEGDEE: Diethylene glycol diethyl ether

DEGMBE: Diethylene glycol monobutyl ether

DPGMME: Dipropylene glycol monomethyl ether

TPGMME: Tripropylene glycol monomethyl ether

PEO-ph: Polyoxyethylene phenyl ether

## Claims

1. Use of a cleaning agent comprising a mixture of
(A) at least one glycol ether compound represented by general formula (1):

$$R^1O-(CH_2\overset{\overset{\displaystyle R^3}{|}}{C}HO)_n-R^2 \qquad (1)$$

wherein $R^1$ is a hydrogen atom or an alkyl group having 1 to 5 carbon atoms, $R^2$ is an alkyl group having 1 to 5 carbon atoms, $R^3$ is a hydrogen atom or a methyl group and n is an integer of 2 to 4, and
(B) at least one nonionic surfactant; for removal of a rosin-base solder flux.

2. Use according to claim 1 wherein the nonionic surfactant is a surfactant represented by general formula (2):

$$R\text{-}O\text{-}(CH_2CH_2O)_n\text{-}H \qquad (2)$$

wherein R is a straight- or branched-chain alkyl group having 6 to 20 carbon atoms, a phenyl group or a phenyl group substituted with a straight- or branched-chain alkyl group having 7 to 12 carbon atoms and n is an integer of 2 to 20.

3. Use according to claim 1 or 2 wherein the mixture comprises 95 to 10 wt.% of glycol ether compound of general formula (1) and 5 to 90 wt.% of nonionic surfactant.

4. Use according to claim 3 wherein the mixture comprises 90 to 70 wt.% of glycol ether compound of general formula (1) and 10 to 30 wt.% of nonionic surfactant.

5. Use according to any one of claims 1 to 4 wherein the cleaning agent further contains water.

6. Use according to claim 5 wherein the cleaning agent contains said mixture of the active ingredients (A) and (B) at a concentration of more than 50% by weight but less than 100% by weight.

7. A cleaning method for removing a rosin-base solder flux, the method comprising bringing a cleaning agent into contact with the flux on a printed wiring board, the cleaning agent comprising a mixture of
(A) at least one glycol ether compound represented by general formula (1):

$$R^1O-(CH_2\overset{\overset{\displaystyle R^3}{|}}{C}HO)_n-R^2 \qquad (1)$$

wherein $R^1$ is a hydrogen atom or an alkyl group having 1 to 5 carbon atoms, $R^2$ is an alkyl group having 1 to 5 carbon atoms, $R^3$ is a hydrogen atom or a methyl group and n is an integer of 2 to 4, and

(B) at least one nonionic surfactant.

8. Method according to claim 7 wherein the nonionic surfactant is a surfactant represented by general formula (2):

$$R\text{-}O\text{-}(CH_2CH_2O)_n\text{-}H \qquad (2)$$

wherein R is a straight- or branched-chain alkyl group having 6 to 20 carbon atoms, a phenyl group or a phenyl group substituted with a straight- or branched-chain alkyl group having 7 to 12 carbon atoms and n is an integer of 2 to 20.

9. Method according to claim 7 or 8 wherein the mixture comprises 95 to 10 wt.% of glycol ether compound of general formula (1) and 5 to 90 wt.% of nonionic surfactant.

10. Method according to claim 9 wherein the mixture comprises 90 to 70 wt.% of glycol ether compound of general formula (1) and 10 to 30 wt.% of nonionic surfactant.

11. Method according to any one of claims 7 to 10 wherein the cleaning agent further contains water.

12. Method according to claim 11 wherein the cleaning agent contains said mixture of the active ingredients (A) and (B) at a concentration of more than 50% by weight but less than 100% by weight.

13. Method according to any one of claims 7 to 12 wherein the cleaning agent is brought into contact with the rosin-base solder flux on a printed wiring board for a time period and at a temperature effective for removal of the flux.

14. Method according to claim 13 wherein the cleaning agent is brought into contact with the rosin-base solder flux at about room temperature.

15. Method according to any one of claims 7 to 14 which further comprises the step of washing the printed wiring board with water.

## Patentansprüche

1. Verwendung eines Reinigungsmittels, das eine Mischung von
(A) wenigstens einer Glykoletherverbindung, die durch die allgemeine Formel (1) dargestellt wird:

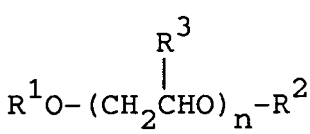

(1)

worin $R^1$ ein Wasserstoffatom oder eine Alkylgruppe mit 1 bis 5 Kohlenstoffatomen ist, $R^2$ für eine Alkylgruppe mit 1 bis 5 Kohlenstoffatomen steht, $R^3$ ein Wasserstoffatom oder eine Methylgruppe darstellt und n eine ganze Zahl von 2 bis 4 ist, und
(B) wenigstens einem nicht-ionischen Tensid; umfaßt, für die Entfernung eines Lötflußmittels auf Kolophoniumbasis.

2. Verwendung nach Anspruch 1, bei der das nicht-ionische Tensid ein Tensid ist, das durch die allgemeine Formel (2) dargestellt wird:

$$R\text{-}O\text{-}(CH_2CH_2O)_n\text{-}H \qquad (2)$$

worin R für eine geradkettige oder verzweigte Alkylgruppe mit 6 bis 20 Kohlenstoffatomen, eine Phenylgruppe oder eine Phenylgruppe, die mit einer geradkettigen oder verzweigten Alkylgruppe mit 7 bis 12 Kohlenstoffatomen substituiert ist, steht, und n eine ganze Zahl von 2 bis 20 darstellt.

3. Verwendung nach Anspruch 1 oder 2, bei der die Mischung 95 bis 10 Gew.-% Glykoletherverbindung der allgemeinen Formel (1) und 5 bis 90 Gew.-% nicht-ionisches Tensid umfaßt.

4. Verwendung nach Anspruch 3, bei der die Mischung 90 bis 70 Gew.-% Glykoletherverbindung der allgemeinen Formel (1) und 10 bis 30 Gew.-% nicht-ionisches Tensid umfaßt.

**5.** Verwendung nach irgendeinem der Ansprüche 1 bis 4, bei der das Reinigungsmittel weiter Wasser enthält.

**6.** Verwendung nach Anspruch 5, bei der das Reinigungsmittel die Mischung der aktiven Bestandteile (A) und (B) bei einer Konzentration von mehr als 50 Gew.-%, aber weniger als 100 Gew.-%, enthält.

**7.** Reinigungsverfahren zur Entfernung eines Lötflußmittels auf Kolophonium-Basis, umfassend das Inberührungbringen eines Reinigungsmittels mit dem Flußmittel auf einer gedruckten Verdrahtungsplatte,wobei das Reinigungsmittel eine Mischung von

(A) wenigstens einer Glykoletherverbindung, die durch die allgemeine Formel (1) dargestellt wird:

$$R^1O-(CH_2\overset{\overset{\displaystyle R^3}{|}}{C}HO)_n-R^2 \qquad (1)$$

worin $R^1$ ein Wasserstoffatom oder eine Alkylgruppe mit 1 bis 5 Kohlenstoffatomen ist, $R^2$ für eine Alkylgruppe mit 1 bis 5 Kohlenstoffatomen steht, $R^3$ ein Wasserstoffatom oder eine Methylgruppe darstellt und n eine ganze Zahl von 2 bis 4 ist, und

(B) wenigstens einem nicht-ionischen Tensid; umfaßt.

**8.** Verfahren nach Anspruch 7, bei welchem das nicht-ionische Tensid ein Tensid ist, das durch die allgemeine Formel (2) dargestellt wird:

$$R\text{-}O\text{-}(CH_2CH_2O)_n\text{-}H \qquad (2)$$

worin R für eine geradkettige oder verzweigte Alkylgruppe mit 6 bis 20 Kohlenstoffatomen, eine Phenylgruppe oder eine Phenylgruppe, die mit einer geradkettigen oder verzweigten Alkylgruppe mit 7 bis 12 Kohlenstoffatomen substituiert ist, steht, und n eine ganze Zahl von 2 bis 20 darstellt.

**9.** Verfahren nach Anspruch 7 oder 8, bei welchem die Mischung 95 bis 10 Gew.-% Glykoletherverbindung der allgemeinen Formel (1) und 5 bis 90 Gew.-% nicht-ionisches Tensid umfaßt.

**10.** Verfahren nach Anspruch 9, bei welchem die Mischung 90 bis 70 Gew.-% Glykoletherverbindung der allgemeinen Formel (1) und 10 bis 30 Gew.-% nicht-ionisches Tensid umfaßt.

**11.** Verfahren nach irgendeinem der Ansprüche 7 bis 10, bei welchem das Reinigungsmittel weiter Wasser enthält.

**12.** Verfahren nach Anspruch 11, bei welchem das Reinigungsmittel die Mischung der aktiven Bestandteile (A) und (B) bei einer Konzentration von mehr als 50 Gew.-%, aber weniger als 100 Gew.-%, enthält.

**13.** Verfahren nach irgendeinem der Ansprüche 7 bis 12, bei welchem das Reinigungsmittel mit dem Lötflußmittel auf Kolophonium-Basis auf einer gedruckten Verdrahtungsplatte für eine Zeitspanne und bei einer Temperatur in Berührung gebracht wird, die für die Entfernung des Flußmittels wirksam sind.

**14.** Verfahren nach Anspruch 13, bei welchem das Reinigungsmittel mit dem Lötflußmittel auf Kolophonium-Basis etwa bei Raumtemperatur in Berührung gebracht wird.

**15.** Verfahren nach irgendeinem der Ansprüche 7 bis 14, welches weiter die Stufe des Waschens der gedruckten Verdrahtungsplatte mit Wasser umfaßt.

## Revendications

**1.** Utilisation d'un agent de nettoyage comprenant un mélange de :

(A) au moins un composé éther de glycol représenté par la formule générale (1) :

$$R^1O-(CH_2\overset{\overset{\displaystyle R^3}{|}}{C}HO)_n-R^2 \qquad (1)$$

dans laquelle $R^1$ est un atome d'hydrogène ou un groupe alkyle comportant de 1 à 5 atomes de carbone, $R^2$ est un groupe alkyle comportant de 1 à 5 atomes de carbone, $R^3$ est un atome d'hydrogène ou un groupe méthyle, et n est un nombre entier valant de 2 à 4, et

(B) au moins un agent tensio-actif non ionique ; pour l'élimination d'un flux de brasage à base de colophane.

2. Utilisation selon la revendication 1, dans laquelle l'agent tensio-actif non ionique est un agent tensio-actif représenté par la formule générale (2) :

$$R\text{-}O\text{-}(CH_2CH_2O)_n\text{-}H \qquad (2)$$

dans laquelle R est un groupe alkyle à chaîne droite ou ramifiée, comportant de 6 à 20 atomes de carbone, un groupe phényle ou un groupe phényle substitué par un groupe alkyle à chaîne droite ou ramifiée, comportant de 7 à 12 atomes de carbone, et n est un nombre entier valant de 2 à 20.

3. Utilisation selon la revendication 1 ou 2, dans laquelle le mélange comprend de 95 à 10 % en poids de composé éther de glycol de formule générale (1) et de 5 à 90 % en poids d'agent tensio-actif non ionique.

4. Utilisation selon la revendication 3, dans laquelle le mélange comprend de 90 à 70 % en poids de composé éther de glycol de formule générale (1) et de 10 à 30 % en poids d'agent tensio-actif non ionique.

5. Utilisation selon une quelconque des revendications 1 à 4, dans laquelle l'agent de nettoyage contient aussi de l'eau.

6. Utilisation selon la revendication 5, dans laquelle l'agent de nettoyage contient ledit mélange d'ingrédients actifs (A) et (B) à une concentration de plus de 50% en poids, mais moins de 100 % en poids.

7. Procédé de nettoyage pour éliminer un flux de brasage à base de colophane, comprenant la mise en contact d'un agent de nettoyage avec le flux sur une plaquette à circuit imprimé, l'agent de nettoyage comprenant un mélange de :

(A) au moins un composé éther de glycol représenté par la formule générale (2) :

$$R^1O-(CH_2\overset{\overset{\displaystyle R^3}{|}}{C}HO)_n-R^2 \qquad (1)$$

dans laquelle $R^1$ est un atome d'hydrogène ou un groupe alkyle comportant de 1 à 5 atomes de carbone, $R^2$ est un groupe alkyle comportant de 1 à 5 atomes de carbone, $R^3$ est un atome d'hydrogène ou un groupe méthyle, et n est un nombre entier valant de 1 à 4, et

(B) au moins un agent tensio-actif non ionique.

8. Procédé selon la revendication 7, dans lequel l'agent tensio-actif non ionique est un agent tensio-actif représenté par la formule générale (2) :

$$R\text{-}O\text{-}(CH_2CH_2O)_n\text{-}H \qquad (2)$$

dans laquelle R est un groupe alkyle à chaîne droite ou ramifiée, comportant de 6 à 20 atomes de carbone, un groupe phényle ou un groupe phényle substitué par un groupe alkyle à chaîne droite ou ramifiée, comportant de 7 à 12 atomes de carbone, et n est un nombre entier valant de 2 à 20.

9. Procédé selon la revendication 7 ou 8, dans lequel le mélange comprend de 95 à 10 % en poids de composé éther de glycol de formule générale (1) et de 5 à 90 % en poids d'agent tensio-actif non ionique.

10. Procédé selon la revendication 9, dans lequel le mélange comprend de 90 à 70 % en poids de composé éther de glycol de formule générale (1) et de 10 à 30 % en poids d'agent tensio-actif non ionique.

11. Procédé selon une quelconque des revendications 7 à 10, dans lequel l'agent de nettoyage contient aussi de l'eau.

**12.** Procédé selon la revendication 11, dans lequel l'agent de nettoyage contient ledit mélange d'ingrédients actifs (A) et (B) à une concentration de plus de 50% en poids, mais moins de 100 % en poids.

**13.** Procédé selon une quelconque des revendications 7 à 11, dans lequel l'agent de nettoyage est amené au contact du flux de brasage à base de colophane sur une plaquette à circuit imprimé pendant un laps de temps et à une température efficaces pour l'élimination du flux.

**14.** Procédé selon la revendication 13, dans lequel l'agent de nettoyage est amené au contact du flux de brasage à base de colophane à peu près à la température ambiante.

**15.** Procédé selon une quelconque des revendications 7 à 14, comprenant, en outre, l'étape de lavage de la plaquette à circuit imprimé avec de l'eau.